# DEMANDE DE BREVET EUROPEEN

(11) **EP 1 103 968 A1**
(43) Date de publication de la demande: **30.05.2001**
(21) Numéro de dépôt: 00403327.0
(22) Date de dépôt: 28.11.2000
(51) Int. Cl.: G11B 20/10, G11B 25/04, G11B 25/06, G11B 31/00, B60R 11/02

(54) **Appareil pour la lecture de sons, notamment enregistrés, pouvant être monté sur un véhicule**

(30) Priorité: 29.11.1999 FR 9915029
(71) Demandeur: Seba, Lyes, 75010 Paris (FR)
(72) Inventeur: Seba, Lyes, 75010 Paris (FR)
(74) Mandataire: Rataboul, Michel Charles

(57) **Abrégé**

L'invention concerne un appareil portatif ou monté sur un véhicule, pour la lecture de sons enregistrés sur des supports, soit selon un procédé analogique sur des supports d'enregistrement magnétiques, c'est-à-dire en cassettes, soit selon un procédé numérique sur des disques compacts, comprenant au moins un ensemble de lecture des supports d'enregistrement et un ensemble de diffusion des sons comprenant un amplificateur et au moins un élément de restitution de sons tel qu'un haut parleur.

L'appareil est caractérisé en ce qu'il comprend d'une part un ensemble de lecture (10) comportant au moins un lecteur à l'unité (11-12) de nombreux supports d'enregistrements différents, à savoir un lecteur de cassettes (11) et/ou un lecteur de disques compacts (12), et d'autre part une mémoire numérique de masse (30) dont l'entrée est connectée à la sortie du ou de chaque lecteur (11 - 12) afin qu'elle puisse recevoir et stocker les sons numériques déjà enregistrés sur de nombreux supports différents et diffusés à l'unité, l'appareil comprenant en outre, si nécessaire, un convertisseur analogique/numérique (31), situé entre la sortie d'un lecteur (11) de type analogique et la mémoire numérique de masse (30), laquelle est intercalée entre l'ensemble de lecture (10) et l'élément de diffusion (20).

## Description

Les appareils de lecture de sons enregistrés, comprennent un lecteur proprement dit, de disques, de cassettes, de disques compacts ou de mini disques.

Les disques traditionnels de 15 à 30 centimètres de diamètre, nécessitent des platines tourne-disque très encombrantes et ne sont utilisés que dans des endroits offrant toute la place nécessaire, tant pour les appareils que pour les disques eux-mêmes en plus ou moins grand nombre.

Lorsqu'il s'agit d'appareils devant être montés sur des véhicules, le volume qu'ils occupent est une donnée fondamentale, et la place pour stocker les supports d'enregistrement (disques ou cassettes à bande magnétique) est absolument critique. Mais l'encombrement n'est pas seul en cause, car la situation d'un usager n'est pas du tout la même selon qu'il se trouve dans une habitation ou dans un véhicule.

En effet, se trouver dans une habitation ne nécessite de la part de l'usager ni de se trouver à une place fixe, ni d'être pratiquement immobilisé, ni de devoir se concentrer sur une tâche vitale.

Au contraire, se trouver dans un véhicule, en particulier une voiture de tourisme, exige de l'usager qu'il reste assis à sa place, très limité dans ses mouvements et s'il conduit le véhicule, il doit en outre avoir une vigilance extrême, le regard dirigé vers la route, sans compter la gène supplémentaire que lui occasionne le volant.

Il est donc extrêmement important que la commande de l'ensemble sonore du véhicule soit aussi simple que possible, et l'effort des constructeurs est actuellement de rendre les opérations aussi automatiques que possible. Le récepteur radio, par exemple, est couramment associé à des systèmes de captage automatique de stations locales, ou d'émissions type, etc.

Quant aux supports d'enregistrement, il est impossible de supprimer un minimum de manipulations.

Lorsqu'il s'agit de disques compacts, il faut simplement les engager, un à un, dans une fente, leur mise en place se faisant automatiquement, sans autre intervention de l'usager. La fin de leur programme entraîne aussi automatiquement leur arrêt et pour retirer celui qui était en place, il suffit d'appuyer sur une bouton pour provoquer son apparition sur une fraction de sa surface suffisante pour le saisir.

Lorsqu'il s'agit de cassettes, il faut les engager, une à une, dans un logement protégé par un volet librement pivotant et souvent actionner un bouton de mise en marche. La fin de leur programme n'entraîne pas nécessairement leur arrêt si l'appareil est muni d'un système dit " auto reverse " qui enchaîne les deux faces de la bande magnétique.

Mais le problème réellement grave qui se pose dans le cas des disques comme dans celui des cassettes est leur rangement et les manipulations indispensables à l'extraction et au rangement, surtout si l'usager est soigneux et s'impose de remettre le disque dans son étui, la cassette dans son boîtier.

Pour simplifier ces opérations manuelles difficiles et dangereuses, on a réalisé des changeurs de disques qui sont des appareils relativement encombrants et que l'on ne peut placer que dans le coffre du véhicule où il constitue une gène certaine, ou dans la boîte à gants qu'il occupe pratiquement en entier.

L'installation d'un tel changeur est de toutes façons complexe, notamment parce que la liaison entre le boîtier son (radio et au moins un lecteur) et le changeur distant se fait non par un simple câble mais par un conducteur optique à fibres, qui impose des contraintes parfois sévères car il faut respecter un rayon de courbure minimum, éviter les pincements, etc. ce qui nécessite l'intervention d'un personnel qualifié et bien formé. De plus, les disques doivent être mis en place dans un chargeur qui a une capacité limitée, de sorte que si l'usager souhaite, en route, écouter un disque qu'il n'a pas préalablement introduit dans le chargeur, ou bien s'il souhaite remplacer les disques qu'il a écoutés, par. d'autres, il est obligé d'arrêter le véhicule, d'en descendre, d'ouvrir le coffre, de décharger les bagages pour atteindre le changeur de disques, retirer les disques que contient le chargeur et les remplacer par d'autres, ce qui suppose le rangement des premiers et l'extraction des seconds hors de leur emplacement de rangement, puis la remise en place des bagages, etc.

Quant aux cassettes, leur constitution elle-même et leur mode de lecture n'a pas permis jusqu'à ce jour de réaliser un changeur pratique car il faudrait autant d'ensembles de lecture, d'avancement, d'arrêt, de recul, que l'on souhaite de cassettes différentes.

La miniaturisation des disques compacts a conduit aux mini disques dont le diamètre n'est que de quelques centimètres mais ces disques ne changent rien de fondamental dans la situation qui vient d'être décrite.

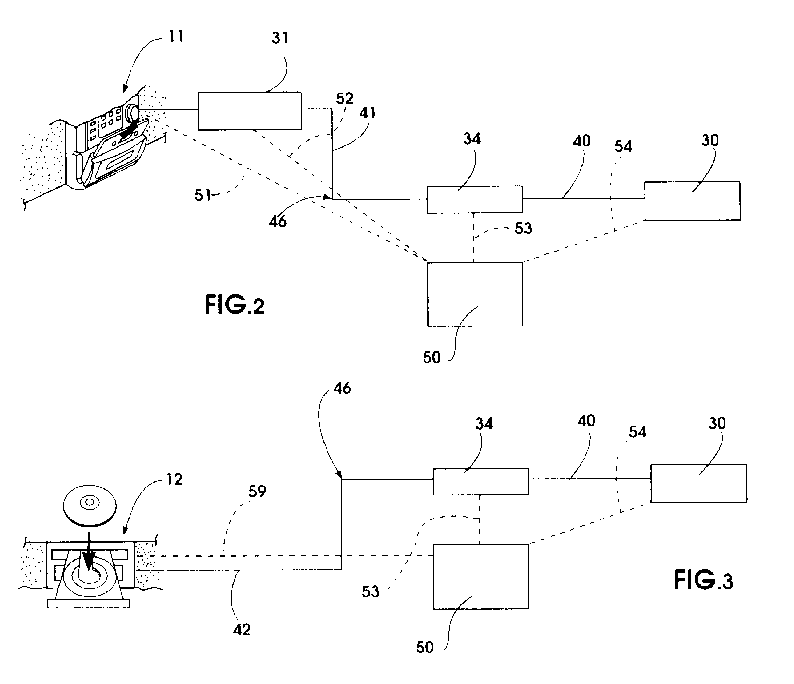

Par ailleurs, on connaît des appareils du genre dictaphone dont le circuit comprend des convertisseurs analogique / numérique et numérique / analogique, et notamment :
■ le document US 5 923 624 qui décrit un dictaphone devant être combiné à un autoradio et comprenant, pour cela, un micro pour la dictée et un ensemble d'enregistrement de type connu. L'appareil comprend deux parties séparables dont l'une est dite « partie opérationnelle amovible » sans laquelle l'autoradio ne peut fonctionner (colonne 3, lignes 11-12).
   L'autoradio ne possède aucun lecteur de sons enregistrés, la liaison entre le décodeur 24 et la mémoire digitale 12 représentée sur la figure 2 ne sert qu'à enregistrer les messages émis en numérique et de type particulier tel que celui connu sous le nom de « ARI » qui communique des informations parlées concernant un domaine préalablement sélectionné par l'auditeur (sports, actualités, etc.).
   La mémoire analogique a une très faible capacité qui se mesure en minutes d'audition (colonne 3, lignes 42-49), ce qui montre que l'invention s'applique exclusivement à la gestion de paroles, soit qu'elles soient enregistrées très occasionnellement à partir de brefs messages reçus d'une antenne, soit qu'elles aient été dictées par l'usager lui-même dans la « partie opérationnelle» séparée de l'autoradio ;
■ le document EP 1 001 428 qui décrit un dictaphone comprenant un micro et un ensemble d'enregistrement incorporant un système de compression du signal. Cette invention ne concerne pas la gestion de mémoire de masse pour des données enregistrées, au sein d'un appareil n'ayant aucun micro ;
■ le document US 6 061 306 qui concerne une cassette comprenant un émulateur permettant de rendre compatibles avec une tête de lecture analogique, des données stockées sous forme numérique.

Cette disposition n'a aucun point commun avec l'invention étudiée.

La présente invention propose une solution nouvelle qui se différencie nettement des éléments connus de l'État de la Technique et qui permet de s'affranchir de toutes les manipulations individuelles des supports d'enregistrement.

A cette fin, l'invention a pour objet un appareil portatif ou monté sur un véhicule, pour la lecture de sons enregistrés sur des supports, soit selon un procédé analogique sur des supports d'enregistrement magnétiques, c'est-à-dire en cassettes, soit selon un procédé numérique sur des disques compacts, comprenant au moins un ensemble de lecture des supports d'enregistrement et un ensemble de diffusion des sons comprenant un amplificateur et au moins un élément de restitution de sons tel qu'un haut parleur, caractérisé en ce qu'il comprend d'une part un ensemble de lecture comportant au moins un lecteur à l'unité de nombreux supports d'enregistrements différents, à savoir un lecteur de cassettes et/ou un lecteur de disques compacts, et d'autre part une mémoire numérique de masse dont l'entrée est connectée à la sortie du ou de chaque lecteur afin qu'elle puisse recevoir et stocker les sons numériques déjà enregistrés sur de nombreux supports différents et diffusés à l'unité, l'appareil comprenant en outre, si nécessaire, un convertisseur analogique/numérique, situé entre la sortie d'un lecteur de type analogique et la mémoire numérique de masse, laquelle est intercalée entre l'ensemble de lecture et l'élément de diffusion.

L'invention sera mieux comprise par la description détaillée ci-après faite en référence au dessin annexé. Bien entendu, la description et le dessin ne sont donnés qu'à titre d'exemple indicatif et non limitatif.

La figure 1 est un schéma général d'un appareil conforme à l'invention, comprenant un lecteur de cassettes et un lecteur de compact disques.

La figure 2 est un schéma correspondant à l'utilisation du seul lecteur de cassettes.

La figure 3 est un schéma correspondant à l'utilisation du seul lecteur de disques compact.

La figure 4 est un schéma correspondant à la seule écoute d'une mémoire numérique.

La figure 5 est une schéma correspondant à l'écoute directe d'une cassette placée dans le lecteur.

La figure 6 est une schéma correspondant à l'écoute directe d'un disque compact placé dans le lecteur.

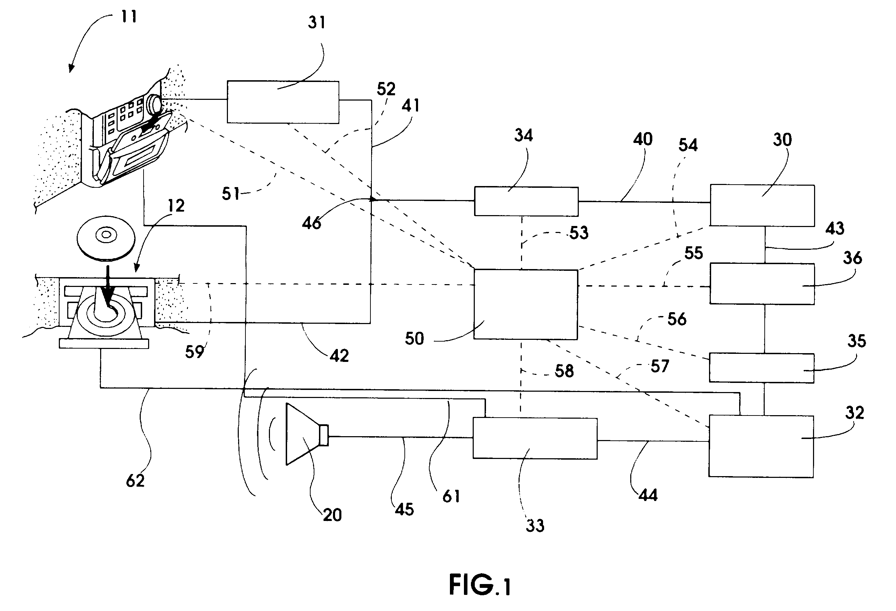

En se reportant au schéma de la figure 1, on voit qu'un appareil conforme à l'invention comporte un lecteur de cassettes 11 de tout type connu en soi et un lecteur de disques compact 12 également de tout type connu, tous deux éventuellement combinés avec un récepteur de radio, ces appareils constituant ensemble, quel que soit leur nombre un ensemble de lecture 10

L'ensemble de lecture 10 est, bien entendu, associé à un tableau de commande (non représenté) comprenant les boutons de commande correspondant aux différentes fonctions des différents lecteurs, et à un ensemble de diffusion 20 symbolisé ici par un simple haut-parleur mais qui, dans la réalité, peut être plus complexe et, en particulier, être composé de plusieurs enceintes éventuellement incorporées à des éléments de l'habitacle du véhicule.

Le circuit complet de l'appareil comprend une mémoire numérique 30 à laquelle aboutit un conducteur d'entrée 40 auquel aboutissent deux conducteurs respectivement 41 issu du lecteur de cassettes 11 et 42 issu du lecteur de disques compacts 12.

Les signaux électriques du lecteur de cassettes 11 sont analogiques et doivent donc être convertis en signaux numériques pour pouvoir être introduits dans la mémoire 30, raison pour laquelle un convertisseur analogique / numérique 31 est intercalé sur le conducteur 41, tandis qu'un tel convertisseur est inutile pour le lecteur de disques compacts puisque les signaux électriques qu'il émet sont de nature numérique.

A la mémoire numérique 30, est raccordé un conducteur de sortie 43 aboutissant un convertisseur numérique / analogique 32, lui-même raccordé par un conducteur 44 à un amplificateur 33 raccordé à l'ensemble de diffusion 20 par un conducteur 45.

Afin de pouvoir stocker un grand nombre de données dans la mémoire numérique 30, un compresseur de type connu 34 est intercalé sur le conducteur 40, entre le point de jonction 46 des conducteurs 41-42 et l'entrée de la mémoire numérique 30.

Les données mémorisées ayant été compressées, il est nécessaire de les décompresser à la sortie de la mémoire numérique 30, avant l'entrée du convertisseur numérique / analogique 32, d'où la présence d'un décompresseur de type connu 35 intercalé sur le conducteur 43.

En raison des inévitables cahots, chocs, vibrations et accélérations / décélérations que subit un véhicule, il est avantageux de disposer une mémoire tampon numérique 36 à la sortie de la mémoire numérique 30 car, selon on applique ici une méthode connue de l'Homme de Métier pour les appareils connus à lecture directe, selon laquelle on crée un retard initial entre l'émission des signaux de sortie d'un lecteur et leur diffusion, par stockage temporaire dans une mémoire tampon des signaux de sortie, de telle sorte que les sons diffusés sont issus non du lecteur directement mais de la mémoire tampon, et tout incident de lecture est éliminé puisqu'il n'est pas pris dans la mémoire tampon.

Il en est de même ici non avec un lecteur de sons mais avec la mémoire numérique 30, comme cela ressortira du fonctionnement ci-après.

L'ensemble de l'installation est supervisée par un contrôleur de type connu 50 ayant des liaisons 51 à 59 respectivement avec le lecteur de cassettes 11, avec le convertisseur analogique / numérique 31, avec le compresseur 34, avec la mémoire numérique 30, avec la mémoire tampon 36, avec le décompresseur 35, avec le convertisseur numérique / analogique 32, avec l'amplificateur 33 et avec le lecteur de disques compacts 12. En outre deux conducteurs 61 et 62 assurent la liaison directe d'une part entre le lecteur 11 et l'amplificateur 33 et d'autre part entre le lecteur 12 et le convertisseur numérique / analogique 32.

Le fonctionnement de l'appareil dont on vient de décrire le schéma d'ensemble est différent selon les diverses possibilités offertes à l'usager et qui sont spécifiques à l'invention car aucun appareil actuellement connu ne possède les mêmes performances. On va donc décrire ce fonctionnement selon ces différentes possibilités :
**1. Mise en mémoire du contenu d'une cassette sans écoute simultanée**
   La figure 2 représente le circuit correspondant qui permet de transférer les signaux de sortie du lecteur 11 au convertisseur 31, au compresseur 34, puis de les introduire dans la mémoire numérique 30.
   Puisque l'usager n'écoute pas ce qu'il enregistre, il est possible d'inclure dans l'appareil de l'invention un accélérateur de lecture, permettant une mise en mémoire à grande vitesse.
   Il est possible aussi de procéder à cet enregistrement sans écoute, tout en écoutant une autre source sonore telle que la radio.
**2. Mise en mémoire du contenu d'un disque compact sans écoute simultanée**
   La figure 3 représente le circuit correspondant qui permet de transférer les signaux de sortie du lecteur 12 au compresseur 34, puis de les introduire dans la mémoire numérique 30.
   Puisque l'usager n'écoute pas ce qu'il enregistre, il est possible d'inclure dans l'appareil de l'invention un accélérateur de lecture, permettant une mise en mémoire à grande vitesse.
   Il est possible aussi de procéder à cet enregistrement sans écoute, tout en écoutant une autre source sonore telle que la radio.
**3. Ecoute des données préalablement stockées dans la mémoire 30**

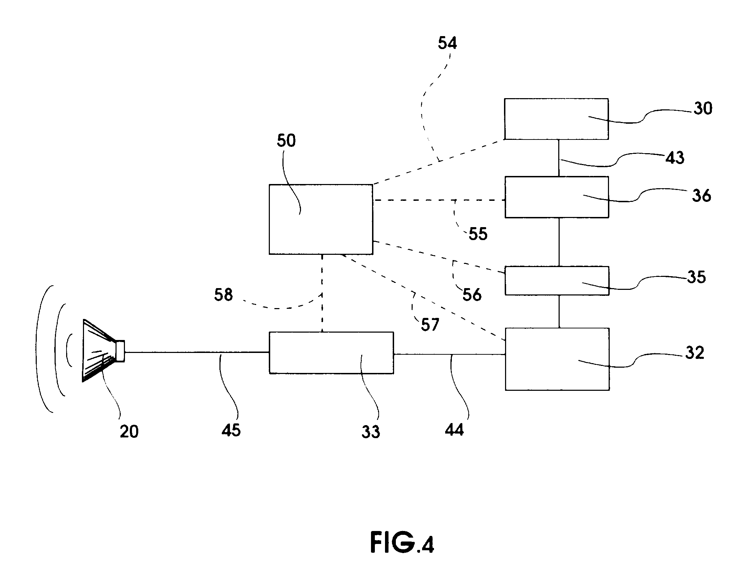

   La figure 4 représente le circuit correspondant qui permet d'accéder aux données de la mémoire 30, via la mémoire tampon 36, le décompresseur 35, le convertisseur numérique / analogique 32, l'amplificateur 33 et l'ensemble de diffusion 20.
**4. Ecoute directe des données d'une cassette, sans mise en mémoire**

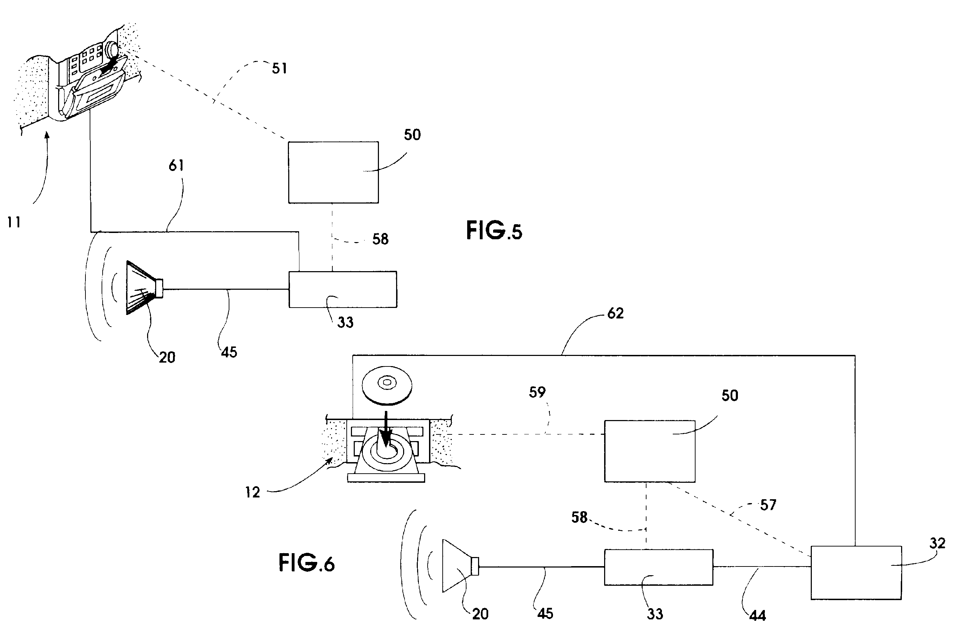

   La figure 5 représente le circuit correspondant, par lequel les signaux électriques issus du lecteur 11 sont directement envoyés à l'amplificateur 33, sans passer par le circuit de la mémoire 30 et de ses compléments.
   On comprend que cela équivaut à un appareil standard, le contrôleur 50 établissant ce circuit par sélection parmi les autres solutions offertes par le circuit complet.
**5. Ecoute directe des données d'un disque compact, sans mise en mémoire**
   La figure 6 représente le circuit correspondant, par lequel les signaux électriques issus du lecteur 12 sont envoyés par le conducteur 62 au convertisseur numérique / analogique 32 puis à l'amplificateur 33, sans passer par le circuit de la mémoire 30 et de ses compléments.
   On comprend que cela équivaut à un appareil standard, mais ici le contrôleur 50 établit ce circuit par sélection parmi les autres solutions offertes par le circuit complet.
   Cependant, il faut souligner que tout appareil comprenant un lecteur utilisant la technologie numérique (disques compacts ou analogues) dispose d'un convertisseur de sortie intégré sans lequel un haut-parleur, qui est de type analogique, ne pourrait pas restituer à l'oreille humaine des sons correspondant à ceux qui ont été enregistrés.
   Cela illustre le fait que l'invention peut s'incarner différemment selon qu'elle est appliquée à un ensemble comprenant des lecteurs standards munis de convertisseurs, d'amplificateurs et/ou d'un ensemble de diffusion préexistants, et agrégés à un circuit conforme à l'invention, ou bien si l'invention, au contraire, donne lieu à la réalisation d'un appareil nouveau.
   C'est ainsi que l'invention peut être concrétisée par un boîtier indépendant connecté à un autoradio comprenant un récepteur radiophonique et au moins un lecteur (cassettes, disques compacts, mini disques), le tout placé dans le logement standard existant sur une voiture, l'ensemble de restitution sonore faisant partie, quant à lui, de l'équipement standard de la voiture ou étant pré installé mais indépendamment de l'appareil comprenant l'invention.
**6. Mise en mémoire du contenu d'un support d'enregistrement avec écoute simultanée**
   C'est très probablement la solution la meilleure pour un usager ayant une nouvelle cassette ou un nouveau disque compact, car il souhaitera sûrement écouter ce qu'il mémorise ou, ce qui revient au même, enregistrer ce qu'il écoute.
   On n'a pas représenté le schéma spécifique à cette utilisation car il s'agit d'une simple combinaison des schémas des figures 2 et 5 pour le lecteur 11, et d'une combinaison des schémas des figures 3 et 6 pour le lecteur 12.

Il ressort de la description ci-dessus, qu'il est dorénavant possible d'éliminer purement et simplement tous les supports d'enregistrements dans un véhicule, ou plus généralement dans tout endroit où cela est souhaité, après qu'ils aient été mémorisés.

Ainsi, un usager peut conserver tous ses supports d'enregistrement à son domicile après qu'il les ait enregistrés, ce qui évite l'actuel dilemme de décider si tel disque doit être conservé au domicile ou dans la voiture.

Il devient également inutile de prévoir un changeur de disques dans le coffre, et de conserver de manière plus ou moins commode des classeurs de disques ou de cassettes dans la voiture.

Ainsi, outre que l'on évite toute fatigue et usure mécanique des changeurs de disques, on profite de l'incomparable rapidité de l'électronique car un changeur de disques provoque une attente de 8 à 10 secondes entre deux disques alors qu'avec l'invention, le passage d'un enregistrement à un autre peut être quasi instantané, et en tous les cas aucune différence de temps n'existe entre deux enregistrements d'un même disque et deux enregistrements appartenant à deux disques différents et mis en mémoire à des moments différents.

On comprend également que la mise en mémoire des supports d'enregistrement permet de garder ces supports à l'état neuf puisqu'on peut les écouter autant de fois que l'on veut sans plus y toucher. Lorsqu'il s'agit de supports d'enregistrement conservés dans un véhicule, ils sont non seulement soumis à l'usure de leur utilisation normale mais en plus ils subissent des températures élevées, des agressions de poussière, des chocs et des contraintes de manipulations que l'invention élimine totalement.

Cette grande facilité d'emploi peut conduire à appliquer l'invention non seulement pour des appareils embarqués dans des véhicules mais également pour des usages à poste fixe.

L'invention rend également possible la réalisation de mémoires numériques 30 amovibles et donc interchangeables, chacune ayant une collection de pièces musicales éventuellement spécialisées : rock, danses, classique, etc.

Une telle mémoire peut facilement contenir la totalité des disques compacts représentant une collection telle que toutes les chansons d'un même interprète ou d'un même compositeur. Ainsi, par exemple, une mémoire 30 de 4 giga octets peut contenir l'équivalent de 100 disques compacts environ, selon la durée exacte de chacun d'eux et selon le taux de compression choisi. Cette capacité est à rapprocher de celle des changeurs de disques qui est actuellement de 10 disques compacts maximum et très rarement de 12.

Naturellement, il est possible d'utiliser l'invention non seulement avec des supports d'enregistrement mais aussi avec un récepteur radio ou encore avec un micro pour l'enregistrement direct de la voix humaine ou pour des reportages soniques.

Compte tenu de la très grande capacité des mémoires numériques, surtout associées à un système de compression / décompression du signal, l'invention prévoit que l'usager peut, *ad libitum,* introduire des repères entre les différents morceaux enregistrés, afin de pouvoir les retrouver sélectivement.

Ces repères sont des signaux numériques issus d'un circuit électronique spécifique à l'invention, commandé par un clavier, ou à la voix comme on l'explique ci-après.

On connaît des signaux numériques nommés "CD TEXT" mais il s'agit d'une technologie mise en oeuvre par des appareils réservés aux professionnels et qui ne sont pas compatibles avec le très faible encombrement qu'exige un appareil conforme à l'invention, susceptible d'être contenu dans un boîtier du format des autoradios standards.

De plus, ces signaux sont enregistrés définitivement sur le disque et ne sont pas placés dans une mémoire modifiable, contrairement à l'invention.

L'ensemble électronique spécifique à l'émission de ces signaux (ou repères) doit être connecté au contrôleur 50 afin que l'usager puisse les introduire dans la mémoire 50 de manière coordonnée avec les signaux mis en mémoire, c'est-à-dire que l'usager choisit les repères en fonction de l'enregistrement et peut les modifier comme il peut effacer et remplacer des enregistrements déjà mémorisés.

Les voitures modernes possèdent un écran d'affichage souvent associé à un ordinateur, et il est donc facile de concevoir un appareil incorporant la présente invention et assurant l'affichage des données intéressantes, notamment les repères placés par l'usager entre les morceaux enregistrés, afin que l'usager puisse dérouler la liste des différents enregistrements mis en mémoire, pour les sélectionner, voire pour les effacer sélectivement et les remplacer.

A la commande classique par clavier, on peut substituer ou ajouter une commande à la voix comportant un capteur, c'est-à-dire un micro, et un transducteur transformant les paroles ou les sons de l'usager en signaux électriques, ainsi qu'un convertisseur analogique / numérique pour placer dans la mémoire 50 des sons directement émis par l'usager qui peut, alors, donner le titre d'un morceau de musique, ou introduire d'autres commentaires, soit immédiatement audibles et compréhensibles, soit inaudibles.

Cependant, il doit être compris que l'appareil conforme à l'invention est totalement indépendant de tout ordinateur et si l'on a fait allusion ci-dessus à la présence d'un ordinateur embarqué, c'est uniquement pour profiter des facilités qu'il peut procurer pour la production de repères entre les enregistrements mémorisés. En effet, il est aussi possible de créer de tels repères sans aucun ordinateur, notamment par émission de messages vocaux.

## Revendications

1. Appareil portatif ou monté sur un véhicule, pour la lecture de sons enregistrés sur des supports, soit selon un procédé analogique sur des supports d'enregistrement magnétiques, c'est-à-dire en cassettes, soit selon un procédé numérique sur des disques compacts, comprenant au moins un ensemble de lecture des supports d'enregistrement et un ensemble de diffusion des sons comprenant un amplificateur et au moins un élément de restitution de sons tel qu'un haut parleur, caractérisé en ce qu'il comprend d'une part un ensemble de lecture (10) comportant au moins un lecteur à l'unité (11-12) de nombreux supports d'enregistrements différents, à savoir un lecteur de cassettes (11) et/ou un lecteur de disques compacts (12), et d'autre part une mémoire numérique de masse (30) dont l'entrée est connectée à la sortie du ou de chaque lecteur (11 - 12) afin qu'elle puisse recevoir et stocker les sons numériques déjà enregistrés sur de nombreux supports différents et diffusés à l'unité, l'appareil comprenant en outre, si nécessaire, un convertisseur analogique/numérique (31), situé entre la sortie d'un lecteur (11) de type analogique et la mémoire numérique de masse (30), laquelle est intercalée entre l'ensemble de lecture (10) et l'élément de diffusion (20).

2. Appareil selon la revendication 1, caractérisé en ce que les sons originels étant de type analogique, l'appareil comprend d'une part un convertisseur analogique / numérique (31) intercalé entre un lecteur (11 de type analogique et la mémoire numérique de masse (30), et d'autre part un convertisseur numérique / analogique (32) placé à l'entrée d'un amplificateur (33) auquel l'élément de diffusion (20) est connecté.

3. Appareil selon la revendication 1, caractérisé en ce qu'il comprend d'une part un compresseur de données (34) placé à l'entrée de la mémoire numérique de masse (30) et d'autre part un décompresseur (35) placé à la sortie de ladite mémoire (30).

4. Appareil selon la revendication 3, caractérisé en ce qu'une mémoire tampon (36) est placée entre la mémoire numérique de masse (30) et l'ensemble de diffusion (20).

5. Appareil selon la revendication 1, caractérisé en ce qu'il comprend un contrôleur (50) et/ou des moyens de commande susceptibles de connecter directement l'ensemble de lecture (10) à l'amplificateur (33), sans intervention de la mémoire numérique de masse (30).

6. Appareil selon la revendication 1, caractérisé en ce qu'il comporte un ensemble d'émission de signaux numériques connecté au contrôleur (50) pour l'introduction de tels signaux numériques dans la mémoire numérique de masse (30), de manière coordonnée avec ceux qui proviennent de l'ensemble de lecture (10), à des fins de rangement en mémoire, de classement et de sélection.

7. Appareil selon la revendication 6, caractérisé en ce que l'ensemble d'émission de signaux numériques, comporte un dispositif de commande à la voix comprenant un capteur de sons et un transducteur, afin que les signaux soient issus de messages émis par la voix de l'usager.
